# EUROPEAN PATENT APPLICATION

(11) **EP 4 597 158 A1**
(43) Date of publication of application: **06.08.2025**
(21) Application number: 23872031.2
(22) Date of filing: 19.09.2023
(51) Int. Cl.: G01S 7/481, G01S 17/894

(54) **RANGING DEVICE, AND METHOD FOR MANUFACTURING SAME**

(30) Priority: 27.09.2022 JP 2022154153
(71) Applicant: Sony Semiconductor Solutions Corporation, Atsugi-shi, Kanagawa 243-0014 (JP)
(72) Inventor: SUZUKI Ryosuke, Atsugi-shi, Kanagawa 243-0014 (JP); FUKUNAGA Hiroshi, Atsugi-shi, Kanagawa 243-0014 (JP); OTAKE Yusuke, Atsugi-shi, Kanagawa 243-0014 (JP); WAKANO Toshifumi, Atsugi-shi, Kanagawa 243-0014 (JP); ASAYAMA Go, Atsugi-shi, Kanagawa 243-0014 (JP)
(74) Representative: MFG Patentanwälte Meyer-Wildhagen Meggle-Freund Gerhard PartG mbB
(86) International application number: PCT/JP2023/033872
(87) International publication number: WO 2024/070803

(57) **Abstract**

[Problem] To perform distance measurement processing with low power consumption while enabling miniaturization and cost reduction.

[Solution] A distance-measuring device measures a distance to an object based on a reflected light signal received by a light-receiving portion, the reflected light signal being generated when a light pulse signal emitted from a light-emitting portion is reflected by the object. The distance-measuring device includes a first substrate formed of a Group-IV material on which the light-receiving portion and the light-emitting portion are integrally arranged; and a second substrate which is laminated on the first substrate and on which a readout circuit for reading out a light-reception signal received by the light-receiving portion is arranged.

## Description

### [Technical Field]

The present disclosure relates to a distance-measuring device and a manufacturing method thereof.

### [Background Art]

A ToF (Time of Flight) LiDAR (Light Detection And Ranging) device, which irradiates an object with a light pulse signal emitted from a light-emitting portion and receives the reflected light pulse signal reflected by the object with a light-receiving portion to measure the distance to the object, is a key device in automated driving technology, and research and development is being actively conducted to measure distances with high accuracy (see PTL 1).

### [Citation List]

### [Patent Literature]

[PTL 1]
JP 2021-27358 A

### [Summary]

### [Technical Problem]

Since the light-emitting portion and the light-receiving portion have different structures, the light-emitting portion and the light-receiving portion are often manufactured separately and mounted on a common support substrate. For this reason, LiDAR takes time to manufacture, miniaturization is difficult, and power consumption cannot be reduced.

Therefore, the present disclosure provides a distance-measuring device and a manufacturing method thereof that can be miniaturized and reduced in cost and can perform distance measurement processing with low power consumption.

### [Solution to Problem]

To solve the above problem, the present disclosure provides a distance-measuring device that measures a distance to an object based on a reflected light signal received by a light-receiving portion, the reflected light signal being generated when a light pulse signal emitted from a light-emitting portion is reflected by the object, the distance-measuring device including: a first substrate formed of a Group-IV material on which the light-receiving portion and the light-emitting portion are integrally arranged; and a second substrate which is laminated on the first substrate and on which a readout circuit for reading out a light-reception signal received by the light-receiving portion is arranged.

The light-receiving portion and the light-emitting portion may be monolithically arranged on the first substrate.

The first substrate may be a silicon substrate.

The light-emitting portion may contain a compound semiconductor material or a mixed crystal of the compound semiconductor material.

A buffer layer may be arranged on the first substrate and formed of a Group-IV material different from the material of the first substrate, the light-emitting portion is arranged on the buffer layer, and the material of the buffer layer has a lattice spacing closer to a lattice spacing of the light-emitting portion than the material of the first substrate.

The light-receiving portion may include a photodiode, an avalanche photodiode, or a SPAD (Single Photon Avalanche Diode).

At least a portion of the light-receiving portion may overlap with the readout circuit when viewed in a plan view from a normal direction of a substrate surface of the first substrate.

The light-emitting portion may be arranged on the first substrate by selective epitaxial growth.

The distance-measuring device may include a light-shielding member containing a metal material arranged between an arrangement region of the light-receiving portion on the first substrate and an arrangement region of the light-emitting portion on the first substrate.

The light-emitting portion may be arranged along a surface of the first substrate opposite to a surface facing the second substrate.

The light-emitting portion may be arranged inside the first substrate.

The second substrate may include a driving circuit that supplies a drive voltage to the light-emitting portion.

At least a portion of the light-emitting portion may overlap with the driving circuit when viewed in a plan view from a normal direction of a substrate surface of the first substrate.

The distance-measuring device may further include a bonding member extending in a depth direction of the first substrate to connect the light-emitting portion and the driving circuit, at least a portion of the bonding member may be arranged in a region overlapping with the light-emitting portion when viewed in a plan view from the normal direction of the substrate surface of the first substrate.

The distance-measuring device may further include a bonding member extending in the depth direction of the first substrate to connect the light-emitting portion and the driving circuit, and at least a portion of the bonding member may be arranged in a region not overlapping with the light-emitting portion when viewed in a plan view from the normal direction of the substrate surface of the first substrate.

The driving circuit may be arranged in a region not overlapping with the light-emitting portion when viewed in a plan view from the normal direction of the substrate surface of the first substrate.

A portion of circuits included in the readout circuit may be arranged on the first substrate, the light-receiving portion may have a plurality of photoelectric conversion elements arranged in a two-dimensional direction, each of which receives light, and the portion of the circuits may have a plurality of pixel circuits connected to each of the plurality of photoelectric conversion elements.

The first substrate may have the light-emitting portions and the light-receiving portions arranged adjacent to each other, each of the light-emitting portions may have a plurality of light-emitting elements arranged closely to each other, and each of the light-receiving portions may have a plurality of photoelectric conversion elements arranged closely to each other.

The light-emitting portion may have a plurality of light-emitting elements, and the light-receiving portion may have a plurality of light-receiving elements arranged between the plurality of light-emitting elements, or arranged to surround the plurality of light-emitting elements, or arranged to be surrounded by the plurality of light-emitting elements.

The light-emitting portion may be a VCSEL (Vertical Cavity Surface Emitting Laser).

The present disclosure also provides a method for manufacturing a distance-measuring device, including: forming a light-receiving portion in a first region of a first substrate formed of a Group-IV material; forming a buffer layer formed of a Group-IV material different from the material of the first substrate on an upper surface of a second region of the first substrate; forming a light-emitting portion formed of a compound semiconductor material on the buffer layer by selective epitaxial growth; and bonding a second substrate to the first substrate, the second substrate having a readout circuit for reading out a light-reception signal received by the light-receiving portion and a driving circuit for supplying a drive voltage to the light-emitting portion.

### [Brief Description of Drawings]

[Fig. 1]

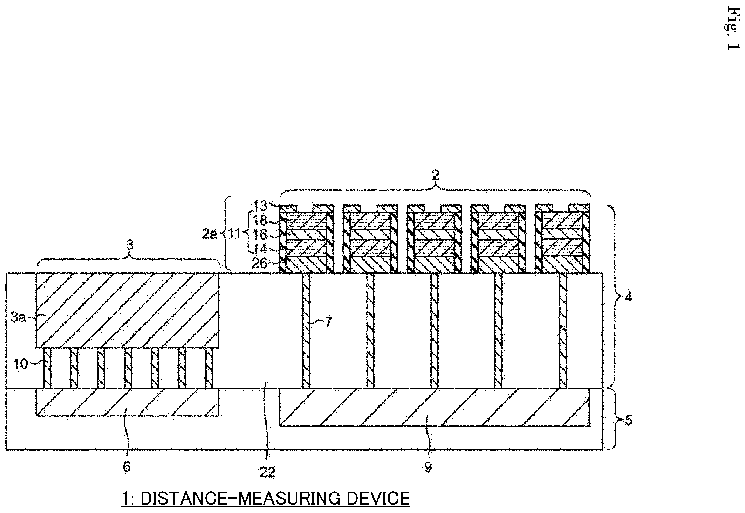

   Fig. 1 is a cross-sectional view showing the cross-sectional structure of a distance-measuring device according to a first embodiment.
[Fig. 2]

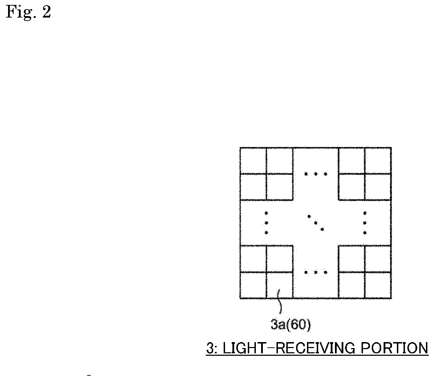

   Fig. 2 is a plan view of the light-receiving portion of Fig. 1.
[Fig. 3A]

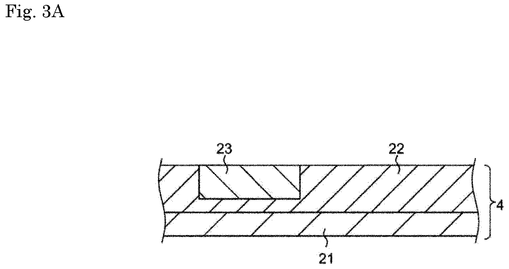

   Fig. 3A is a cross-sectional view showing the manufacturing process of a distance-measuring device according to the first embodiment.
[Fig. 3B]

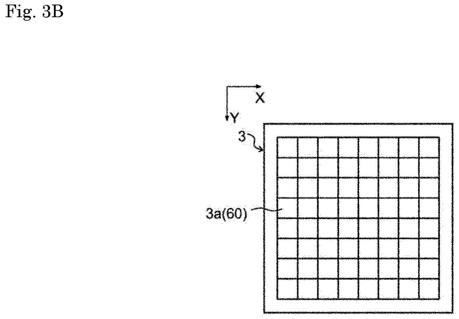

   Fig. 3B is a plan view showing the manufacturing process of a distance-measuring device according to the first embodiment.
[Fig. 3C]

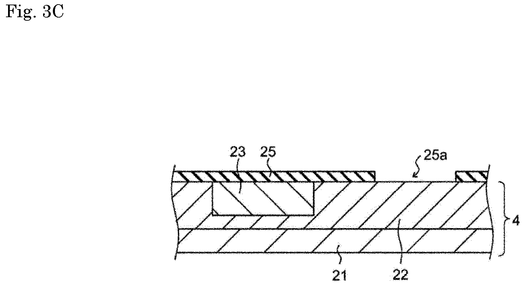

   Fig. 3C is a cross-sectional view showing the process following Fig. 3A.
[Fig. 3D]

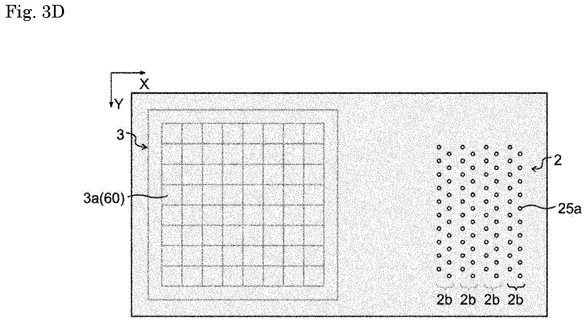

   Fig. 3D is a plan view showing the process following Fig. 3B.
[Fig. 3E]

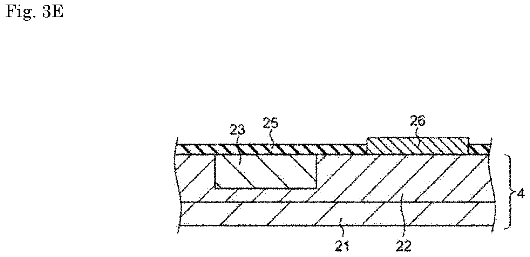

   Fig. 3E is a cross-sectional view showing the process following Fig. 3C.
[Fig. 3F]

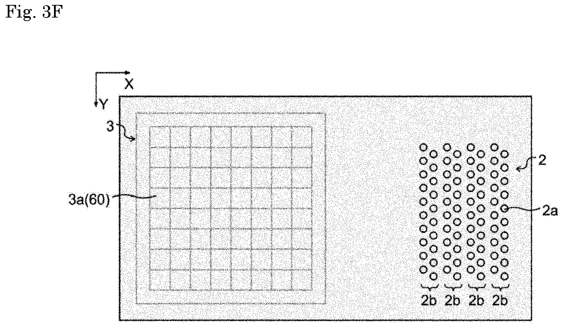

   Fig. 3F is a plan view showing the process following Fig. 3D.
[Fig. 3G]

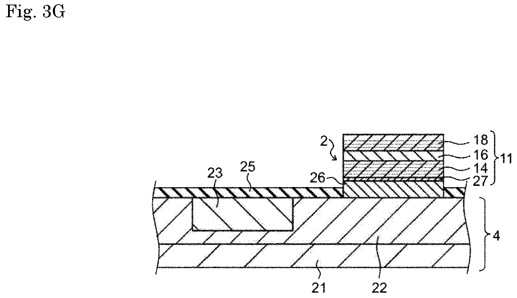

   Fig. 3G is a cross-sectional view showing the process following Fig. 3E.
[Fig. 3H]

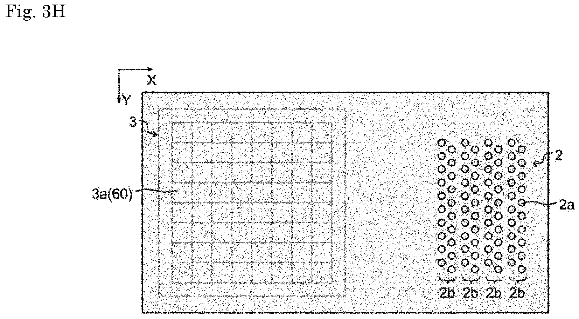

   Fig. 3H is a plan view showing the process following Fig. 3F.
[Fig. 3I]

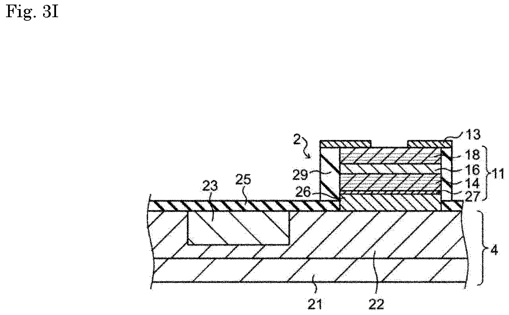

   Fig. 3I is a cross-sectional view showing the process following Fig. 3G.
[Fig. 3J]

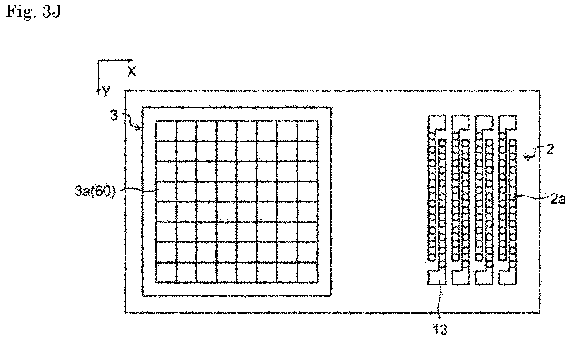

   Fig. 3J is a plan view showing the process following Fig. 3H.
[Fig. 3K]

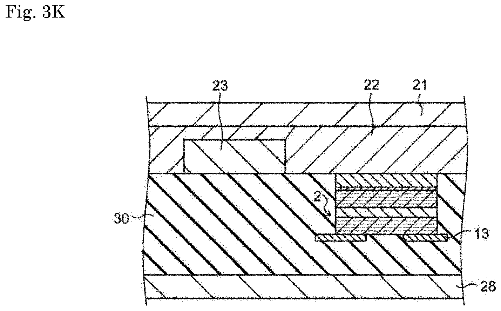

   Fig. 3K is a cross-sectional view showing the process following Fig. 3I.
[Fig. 3L]

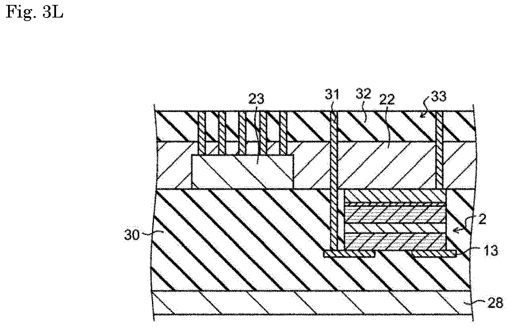

   Fig. 3L is a cross-sectional view showing the process following Fig. 3K.
[Fig. 3M]

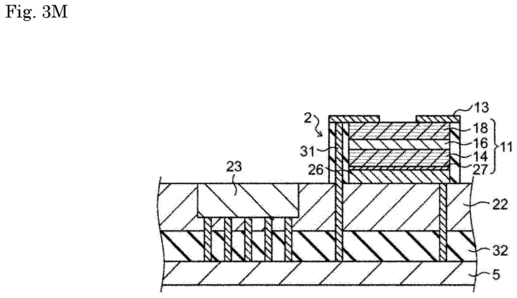

   Fig. 3M is a cross-sectional view showing the process following Fig. 3L.
[Fig. 4]

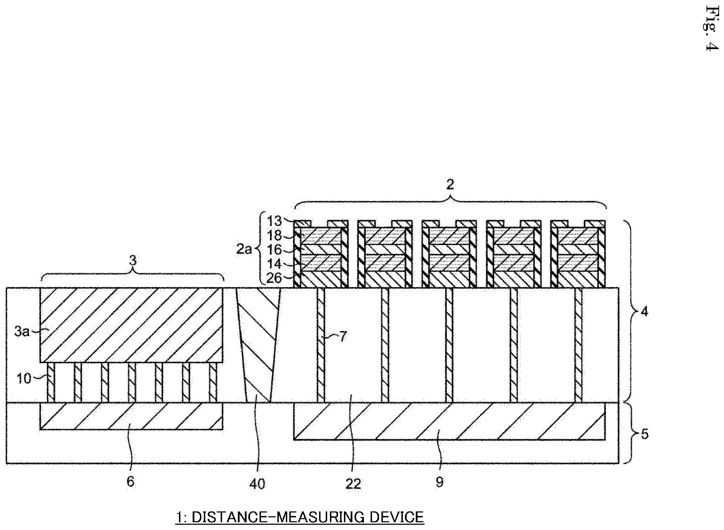

   Fig. 4 is a cross-sectional view of a distance-measuring device according to a second embodiment.
[Fig. 5]

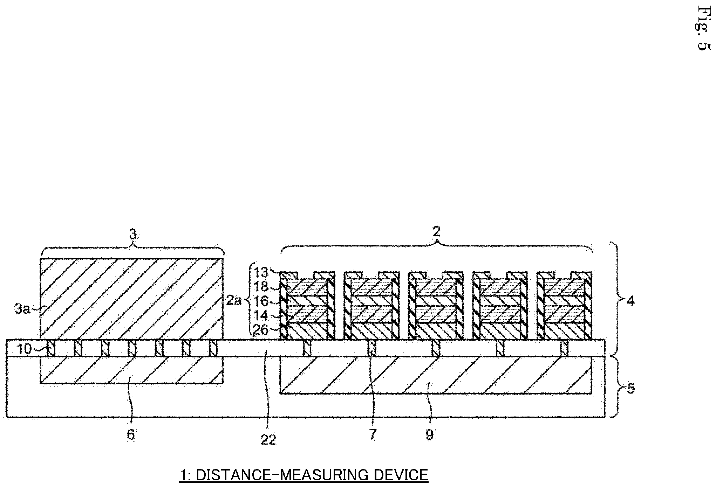

   Fig. 5 is a cross-sectional view of a distance-measuring device according to a third embodiment.
[Fig. 6]

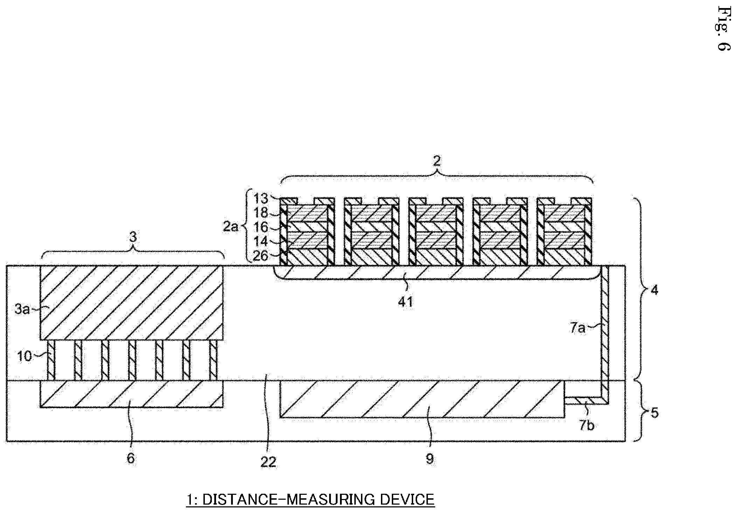

   Fig. 6 is a cross-sectional view of a distance-measuring device according to a fourth embodiment.
[Fig. 7]

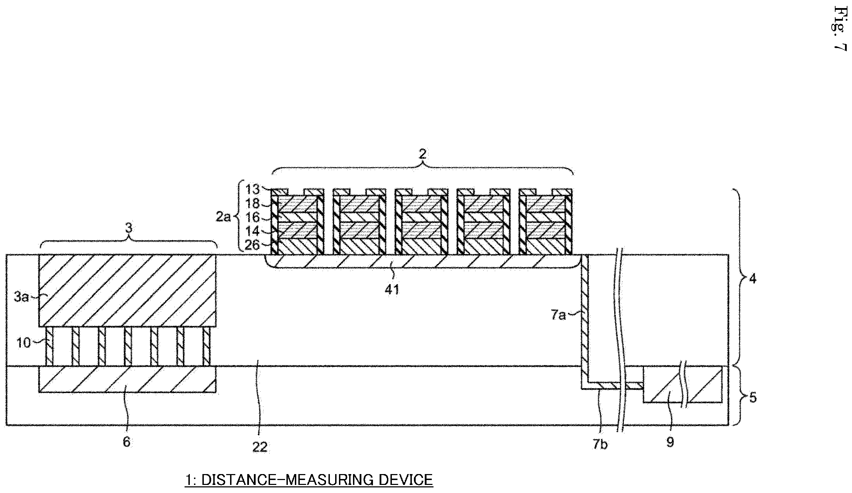

   Fig. 7 is a cross-sectional view of a distance-measuring device according to a fifth embodiment.
[Fig. 8]

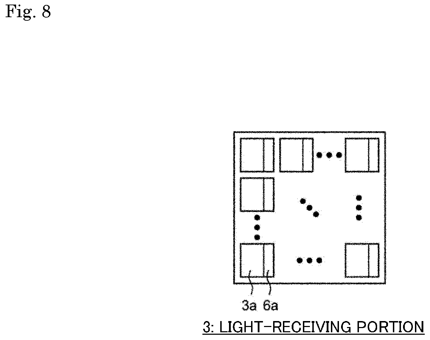

   Fig. 8 is a plan view of the light-receiving portion of a first substrate.
[Fig. 9]

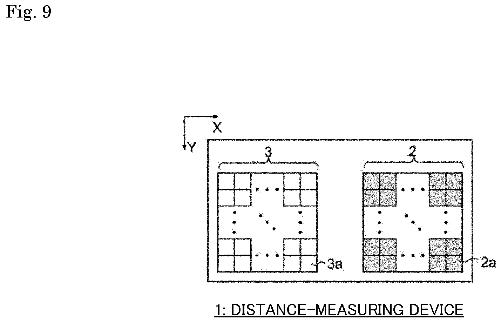

   Fig. 9 is a plan view of a distance-measuring device according to a seventh embodiment.
[Fig. 10]

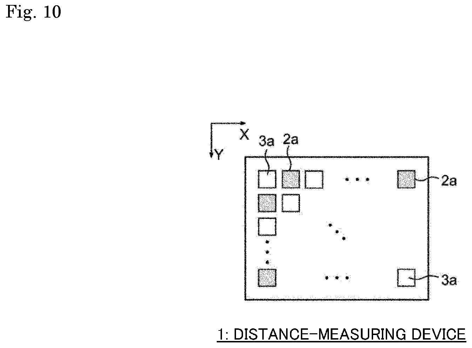

   Fig. 10 is a plan view of a distance-measuring device according to a first modified example of the seventh embodiment.
[Fig. 11]

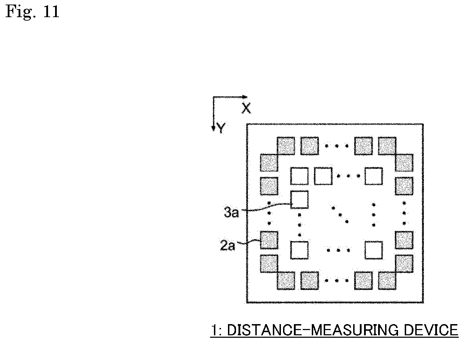

   Fig. 11 is a plan view of a distance-measuring device according to a second modified example of the seventh embodiment.
[Fig. 12]

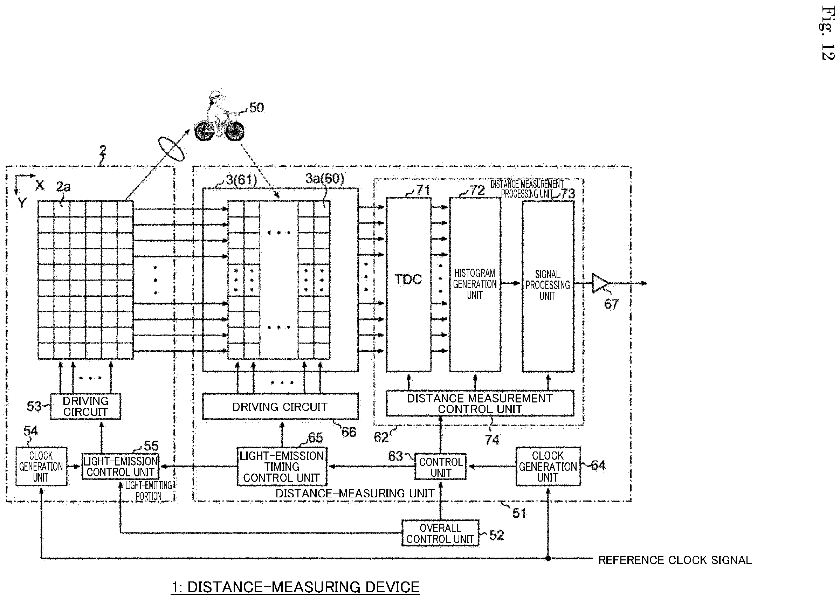

   Fig. 12 is a block diagram of a distance-measuring device according to the first to seventh embodiments.
[Fig. 13]

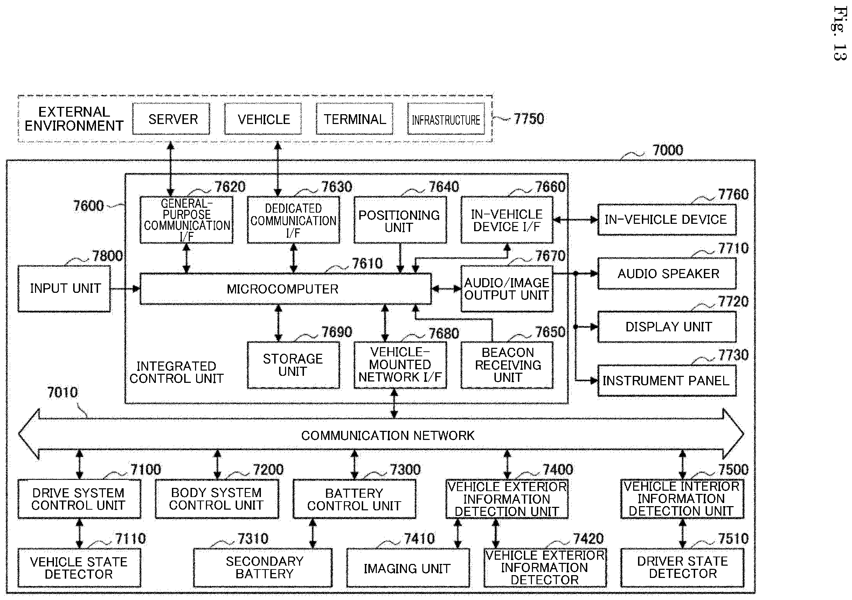

   Fig. 13 is a block diagram illustrating an example of an overall configuration of a vehicle control system.
[Fig. 14]

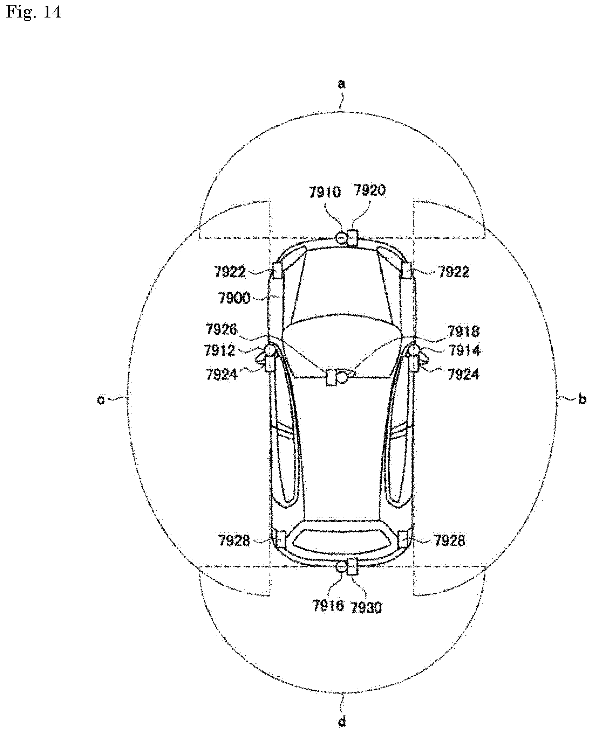

   Fig. 14 is an explanatory diagram illustrating an example of positions at which a vehicle exterior information detector and an imaging unit are installed.

### [Description of Embodiments]

Embodiments of a distance-measuring device and a manufacturing method thereof will be described below with reference to the figures. Although main components of the distance-measuring device and the manufacturing method thereof will be mainly described below, the distance-measuring device and the manufacturing method may have components and functions that are not illustrated or described. The following description does not exclude components or functions that are not illustrated or described.

### (First Embodiment)

Fig. 1 is a cross-sectional view showing the cross-sectional structure of a distance-measuring device 1 according to a first embodiment. The distance-measuring device 1 in Fig. 1 measures the distance to an object based on the reflected light signal received by a light-receiving portion 3, the reflected light signal being generated when a light pulse signal emitted from a light-emitting portion 2 is reflected by the object.

In the distance-measuring device 1 according to the first embodiment, the light-emitting portion 2 and the light-receiving portion 3 are monolithically formed on the same substrate. Monolithic means that the light-emitting portion 2 and the light-receiving portion 3 are formed on the same substrate by a semiconductor process. The light-emitting portion 2 and the light-receiving portion 3 may be formed of the same or different materials.

The distance-measuring device 1 in Fig. 1 has a structure in which a first substrate 4 is bonded to a second substrate 5. When bonding the first substrate 4 to the second substrate 5, various bonding forms such as Cu-Cu bonding, bumps, and vias can be applied.

The first substrate 4 is formed of a Group-IV material. For example, the first substrate 4 is formed of silicon (Si) or germanium (Ge). As described above, in the present embodiment, it is assumed that the light-emitting portion 2 and the light-receiving portion 3 are monolithically formed on the first substrate 4, and the material of the first substrate 4 needs to be selected in consideration of the constituent materials of the light-emitting element and a photoelectric conversion element 3a.

The light-emitting portion 2 is, for example, a semiconductor laser formed of a compound semiconductor material or a mixed crystal of a compound semiconductor material. The compound semiconductor material of the light-emitting portion 2 is, for example, a Group III-V element, specifically, GaAs, InGaAs, InAlGaAs, GaAsSb, GaP, InP, InGaAsP, GaInNAs, and the like.

The light-emitting portion 2 may be a surface light-emitting element having a plurality of light-emitting elements. A representative example of the light-emitting portion 2 is a VCSEL (Vertical Cavity Surface Emitting Laser). The VCSEL has a plurality of light-emitting elements arranged in one or two dimensions, and can emit surface light.

The light-emitting portion 2 is formed, for example, by selective epitaxial growth on the first substrate 4. More specifically, for example, as shown in Fig. 1, the light-emitting portion 2 is formed by selective epitaxial growth on the surface of the first substrate 4 opposite to the surface facing the second substrate 5.

The light-receiving portion 3 is formed in a diffusion region formed by injecting impurities into a portion of the first substrate 4. Alternatively, the light-receiving portion 3 may be formed by laminating on the first substrate 4. Alternatively, the light-receiving portion 3 may be formed so as to be embedded inside the first substrate 4. The light-receiving portion 3 may be a photoelectric conversion element 3a, and the specific structure of the light-receiving portion 3 is not particularly limited. The light-receiving portion 3 may include a plurality of photoelectric conversion elements 3a. The light-receiving portion 3 is, for example, a photoelectric conversion element 3a for a PD (Photo-Diode), an APD (Avalanche Photo-Diode), a SPAD (Single Photon Avalanche Diode), or a ToF (Time of Flight) device.

The material of the photoelectric conversion element 3a is, for example, a silicon-based material, a multi-element material, a perovskite, an organic material, or a quantum dot-based material. The silicon-based material is single crystal silicon, polycrystalline silicon, amorphous silicon, or the like. Germanium may be used instead of silicon. Multi-element materials are CuInSe₂, CdGeP₂, CaGa₂Se₄, or the like. Organic materials are PEDOT:PSS, PCBM, or the like. Quantum dot-based materials are PbS or the like. Note that these are merely examples, and materials other than those exemplified above may be used.

A readout circuit 6 that reads out a light-reception signal received by the light-receiving portion 3 is arranged on the second substrate 5. The light-receiving portion 3 and the readout circuit 6 are bonded by a bonding member 10 such as Cu-Cu bonding, bumps, or vias. The readout circuit 6 is arranged so that at least a portion of the light-receiving portion 3 overlaps with the readout circuit 6 when viewed in a plan view from the normal direction of the substrate surface of the first substrate 4. As a result, by arranging the bonding member 10 extending directly under the light-receiving portion 3, the light-receiving portion 3 and the readout circuit 6 can be bonded by the bonding member 10. When forming the light-emitting portion 2 on the first substrate 4, it is necessary to raise the temperature to a high temperature. For example, if the readout circuit 6 is formed on the first substrate 4 in addition to the light-emitting portion 2, the readout circuit 6 may be damaged by heat. In contrast, in the present embodiment, the light-emitting portion 2 is formed on the first substrate 4, and the readout circuit 6 is formed on the second substrate 5, and then the first substrate 4 and the second substrate 5 are bonded together. Therefore, the readout circuit 6 is not damaged by heat, and the reliability of the distance-measuring device 1 can be improved.

Fig. 2 is a plan view of the light-receiving portion 3 in Fig. 1. As shown in Fig. 2, the light-receiving portion 3 has a plurality of pixels 60 arranged in a two-dimensional direction. The number of pixels 60 that the light-receiving portion 3 has is arbitrary. Each pixel 60 may be physically separated by an element isolation region, or a diffusion region may be arranged in the boundary region between two adjacent pixels 60. Each pixel 60 has the photoelectric conversion element 3a and a pixel circuit. The pixel circuit outputs a pixel signal corresponding to the charge photoelectrically converted by the photoelectric conversion element 3a. For example, if the photoelectric conversion element 3a is a SPAD, the SPAD outputs a pixel signal indicating whether a single photon has been detected. The pixel signal output from each pixel 60 is input to the readout circuit 6 on the second substrate via the bonding member 10.

In addition, a driving circuit 9 that supplies a drive voltage to the light-emitting portion 2 is arranged on the second substrate 5 in Fig. 1. When the light-emitting portion 2 is a semiconductor laser such as a VCSEL, the driving circuit is also called an LDD (Laser Diode Driver) 9. The LDD 9 may be arranged so that at least a portion of the light-emitting portion 2 overlaps with the driving circuit when viewed in a plan view from the normal direction of the substrate surface of the first substrate 4. This allows the distance-measuring device 1 to be made smaller than when the light-emitting portion 2 and the LDD 9 are placed flat.

The light-emitting portion 2 in Fig. 1 is a VCSEL, and has a laminated film 11 arranged on the first substrate 4, a plurality of light-emitting elements 2a formed using the laminated film 11, and an electrode 13.

The laminated film 11 is, for example, a III-V compound semiconductor material such as GaAs. In this specification, the lower surface side of the laminated film 11 in Fig. 1 is called the front surface, and the upper surface side is called the back surface.

The laminated film 11 includes a GaAs layer 27, a first multilayer reflective mirror 14, an active layer 16, and a second multilayer reflective mirror 18. The laser light generated in the active layer 16 resonates between the first multilayer reflective mirror 14 and the second multilayer reflective mirror 18 to increase the light intensity, and is emitted from the back side of the first substrate 4. The first multilayer reflective mirror 14 and the second multilayer reflective mirror 18 are also called DBRs (Distributed Bragg Reflectors) and are formed of, for example, AlGaAs. The active layer 16 is formed of, for example, InGaAs, GainNAs, or GainNSb. The light-emitting portion 2 in Fig. 3 is a back-illuminated type because light is emitted from the back side. Fig. 1 shows the first multilayer reflective mirror 14, the active layer 16, the second multilayer reflective mirror 18, and the cathode electrode 13, which are representative layers of the laminated film 11 constituting the light-emitting element 2a, and other layers are omitted.

The light-emitting elements 2a are formed by processing the laminated film 11 into a mesa shape. An electrode 13 is arranged on the upper surface (back surface) of each light-emitting element 2a. The electrode 13 is an anode electrode or a cathode electrode. In Fig. 1, the arrangement of the electrode 13 is shown in a simplified manner.

The second substrate 5 has an LDD 9 for supplying a drive signal to the light-emitting elements 2a of the first substrate 4. A bonding member 7 is arranged on the LDD 9, and the LDD 9 of the second substrate 5 is electrically connected to the corresponding anode electrode or cathode electrode of the first substrate 4 via the bonding member 7.

Figs. 3A to 3M are cross-sectional views and plan views showing the manufacturing process of the distance-measuring device 1 according to the first embodiment. Figs. 3A, 3C, 3E, 3G, 3I, 3K, 3L, and 3M are cross-sectional process views, and Figs. 3B, 3D, 3F, 3H, and 3J are plan views.

First, as shown in Fig. 3A, a first semiconductor layer 22 is formed on a first support substrate 21 for supporting the first substrate 4, and a second semiconductor layer 23 is further formed inside or on the first semiconductor layer 22. The first semiconductor layer 22 and the second semiconductor layer 23 are laminated on the first support substrate 21, for example. The second semiconductor layer 23 may be a diffusion region formed by injecting impurities into a portion of the first semiconductor layer 22. Alternatively, the second semiconductor layer 23 may be laminated in a trench formed in a portion of the first semiconductor layer 22. The first semiconductor layer 22 and the second semiconductor layer 23 are formed of a semiconductor material such as silicon or germanium. The specific material of the first semiconductor layer 22 and the second semiconductor layer 23 is not particularly limited.

A portion of the first semiconductor layer 22 is arranged in the formation region of the light-emitting portion 2, and the second semiconductor layer 23 is arranged in the formation region of the light-receiving portion 3. In the process of Fig. 3A, the photoelectric conversion element 3a of the light-receiving portion 3 is formed using the second semiconductor layer 23. When the light-receiving portion 3 has a plurality of pixels 60, an element isolation region is arranged in the boundary region of the pixels 60. The element isolation region may be formed of, for example, an insulating layer, or may be formed of a diffusion region formed by injecting impurities. As a result, as shown in Fig. 3B, the light-receiving portion 3 having a plurality of pixels 60 arranged in a two-dimensional direction is formed.

Next, as shown in Fig. 3C, a hard mask layer 25 containing, for example, carbon is arranged on the upper surfaces of the first semiconductor layer 22 and the second semiconductor layer 23, and then patterned. The hard mask layer 25 is patterned on the upper surface of the first semiconductor layer 22 where the light-emitting portion 2 is to be formed. The size of each of the plurality of openings 25a formed by patterning the hard mask layer 25 is adjusted to the size of the light-emitting element 2a. The plurality of openings 25a are formed, for example, in a plurality of rows, as shown in Fig. 3D.

Next, as shown in Fig. 3E, a buffer layer 26 is formed on the first semiconductor layer 22. The buffer layer 26 is formed so as to contact the first semiconductor layer 22 through each of the plurality of openings 25a formed by patterning the hard mask layer 25. The material of the buffer layer 26 is, for example, a Group-IV material different from that of the first semiconductor layer 22. Specifically, the buffer layer 26 may be formed of germanium (Ge). The buffer layer 26 is formed so as to fill the openings 25a as shown in Fig. 3F. The size of the openings 25a is not particularly limited.

The reason for forming the buffer layer 26 on the first semiconductor layer 22 is to make it closer to the lattice spacing of the compound semiconductor material constituting the light-emitting portion 2. In other words, since the lattice spacing of germanium is closer to the lattice spacing of the compound semiconductor material than that of silicon, a buffer layer formed of germanium is arranged on the first substrate 4 so that the buffer layer 26 and the compound semiconductor material layer constituting the light-emitting portion 2 are in contact with each other. This can suppress distortion and crystal defects in the first substrate 4 compared to when the first semiconductor layer 22 on the first substrate 4 is in direct contact with the compound semiconductor material layer.

Next, as shown in the cross-sectional view of Fig. 3G and the plan view of Fig. 3H, the light-emitting portion 2 is formed on the buffer layer 26 by selective epitaxial growth. The light-emitting portion 2 is, for example, the VCSEL shown in Fig. 1, and has a laminated film 11, an anode electrode, and a cathode electrode. The laminated film 11 is, for example, a laminate of a first multilayer reflective mirror 14, an active layer 16, and a second multilayer reflective mirror 18. As described later, a GaAs layer may be arranged between the first multilayer reflective mirror 14 and the buffer layer 26.

The first multilayer reflective mirror 14 is laminated on the buffer layer 26. The first and second multilayer reflective mirrors 14 and 18 are formed of a material such as AlGaAs. The active layer 16 is formed of a material such as InGaAs or GaInNAs (Sb). An AlAs layer may be arranged between the active layer 16 and the multilayer reflective mirror thereon. The sidewalls of the laminated film 11 are protected by an insulating layer 29 such as SiO₂ or SiN.

As described above, each layer constituting the laminated film 11 is formed of a compound semiconductor material, and is sequentially laminated by selective epitaxial growth on a buffer layer formed of germanium. By employing the selective epitaxial growth method, a homogeneous and thin film can be formed in a plurality of layers.

Next, as shown in Fig. 3I, an electrode (for example, a cathode electrode 13) is formed on the upper surface of the light-emitting portion 2. As shown in Fig. 3J, the light-emitting portion 2 has a plurality of light-emitting element groups 2b each arranged along the first direction X and each extending in the second direction Y, and each light-emitting element group 2b has a plurality of light-emitting elements 2a. A cathode electrode 13 is provided for each light-emitting element group 2b. The number and shape of the light-emitting element groups 2b are arbitrary.

Next, as shown in Fig. 3K, the first substrate 4 with the cathode electrode 13 of Fig. 3J facing downward is bonded to the second support substrate 28 arranged thereunder. An insulating layer 30 of SiO₂, SiN, or the like is formed between the second support substrate 28 and the light-emitting portion 2.

Next, as shown in Fig. 3L, the first support substrate 21 is peeled off, and a wiring layer 31 is formed on the first substrate 4 in a post-process. For example, after peeling off the first support substrate 21, an insulating layer 32 formed of SiO₂ is formed, a trench 33 is formed in the insulating layer 32, and a metal material is filled in the trench 33 to form the wiring layer 31.

Next, as shown in Fig. 3M, the second support substrate 28 is peeled off, and the first semiconductor layer 22 is thinned by CMP (Chemical Mechanical Polishing) or the like, and then the second substrate 5 on which the logic circuit is formed is bonded.

The logic circuit formed on the second substrate 5 has an LDD 9 connected to the light-emitting portion 2 and a readout circuit 6 connected to the light-receiving portion 3. The second substrate 5 on which the logic circuit is formed is formed by a manufacturing process separate from the manufacturing processes of Figs. 3A to 3G, and is bonded to the first substrate 4 in the process of Fig. 3H.

The light-emitting portion 2 of the first substrate 4 and the LDD 9 of the second substrate 5 are bonded by a bonding member 7 extending in the depth direction of the first substrate 4, and the light-receiving portion 3 of the first substrate 4 and the readout circuit 6 of the second substrate 5 are bonded by a bonding member 10 extending in the depth direction of the first substrate 4. Thereafter, packaging is performed by covering the periphery of the bonded first substrate 4 and second substrate 5 with resin, for example.

In this way, in the first embodiment, the light-emitting portion 2 and the light-receiving portion 3 are monolithically formed on the first substrate 4, and therefore the manufacturing process can be simplified and the device can be made smaller than when the light-emitting portion 2 and the light-receiving portion 3 are manufactured separately and mounted on the same substrate. By simplifying the manufacturing process, the manufacturing cost of the distance-measuring device 1 can be reduced.

### (Second Embodiment)

The distance-measuring device 1 according to the second embodiment has a light-shielding member arranged between the light-emitting portion 2 and the light-receiving portion 3.

Fig. 4 is a cross-sectional view of the distance-measuring device 1 according to the second embodiment. In Fig. 4, the same components as those in Fig. 1 are designated by the same reference numerals, and differences will be mainly described below.

In the distance-measuring device 1 in Fig. 4, a light-shielding member 40 is arranged between the light-emitting portion 2 and the light-receiving portion 3. The light-shielding member 40 is arranged, for example, so as to penetrate the first substrate 4 in the depth direction.

The light-shielding member 40 is formed, for example, of a metal material such as tungsten that has light-shielding properties against visible light and infrared light. The light-shielding member 40 is arranged, for example, in a boundary region in the direction in which the light-emitting portion 2 and the light-receiving portion 3 are arranged. Alternatively, the light-shielding member 40 may be arranged so as to surround at least one of the light-receiving portion 3 or the light-emitting portion 2.

The light-shielding member 40 may have a height approximately equal to or greater than the height of the light-emitting portion 2. This can improve the light-shielding efficiency even if the light-emitting portion 2 is formed at a higher position than the light-receiving portion 3.

In this way, by providing the light-shielding member 40, it is possible to prevent the light emitted from the light-emitting portion 2 from directly entering the light-receiving portion 3, and the light-receiving portion 3 is not affected by crosstalk, improving the light-receiving characteristics of the light-receiving portion 3.

### (Third Embodiment)

In the third embodiment, the light-emitting portion 2 is arranged immediately above and adjacent to the LDD 9.

Fig. 5 is a cross-sectional view of the distance-measuring device 1 according to the third embodiment. In Fig. 5, the same components as those in Fig. 1 are designated by the same reference numerals, and differences will be mainly described below.

In the distance-measuring device 1 in Fig. 5, the light-emitting portion 2 is arranged inside the first substrate 4, and the light-emitting portion 2 in Fig. 5 is arranged closer to the second substrate 5 than the light-emitting portion 2 in Fig. 1. More specifically, the light-emitting portion 2 in Fig. 5 is arranged immediately above and adjacent to the LDD 9.

The height positions of the bottom surface of the light-emitting portion 2 and the bottom surface of the light-receiving portion 3 may be the same. This allows the height of the bonding member 7 that bonds the light-emitting portion 2 to the LDD 9 to be the same as the height of the bonding member 10 that bonds the light-receiving portion 3 to the readout circuit 6, making the process of forming the bonding members 7 and 10 easier.

In this way, by arranging the light-emitting portion 2 close to the second substrate 5, the height of the first substrate 4 can be reduced, and the height of the distance-measuring device 1 in the state in which the second substrate 5 is bonded to the first substrate 4 can be reduced, resulting in a lighter, thinner, shorter, and smaller device. In addition, the bonding member 7 that bonds the light-emitting element 2a to the LDD 9 and the bonding member 10 that bonds the light-receiving portion 3 to the readout circuit 6 can be shortened, so that the resistance values of the bonding members 7 and 10 can be reduced, and power loss can be suppressed.

### (Fourth Embodiment)

In the fifth embodiment, the bonding member 7 is not arranged directly below the light-emitting portion 2.

Fig. 6 is a cross-sectional view of the distance-measuring device 1 according to the fourth embodiment. In Fig. 6, the same components as those in Fig. 1 are designated by the same reference numerals, and differences will be mainly described below.

In the distance-measuring device 1 of Fig. 6, the light-emitting portion 2 is arranged on the first substrate 4, as in Fig. 1. A diffusion region 41 is arranged in a portion near the upper surface of the first substrate 4 directly below the light-emitting portion 2. This diffusion region 41 is connected to the cathode electrode or anode electrode of the light-emitting portion 2. The diffusion region 41 is a region in which impurity ions are implanted and diffused, and the conductivity of the diffusion region 41 can be increased by adjusting the amount of implanted impurity ions, so that it can be used as a conductive region.

A bonding member 7a is arranged that extends from the end of the diffusion region 41 in the depth direction of the first substrate 4. This bonding member 7a extends to the second substrate 5. The second substrate 5 has a bonding member 7b extending from the LDD 9 in a direction substantially parallel to the substrate surface, and the bonding member 7b is bonded to the bonding member 7a described above.

The distance-measuring device 1 in Fig. 6 has the bonding members 7a and 7b described above, so there is no need to arrange the bonding member 7 directly below the light-emitting portion 2. The region directly below the light-emitting portion 2 can therefore be used for purposes other than the arrangement of the bonding member 7, allowing for a greater degree of freedom in design. In addition, there are fewer restrictions on the location of the bonding member 7 that bonds the light-emitting portion 2 to the LDD 9.

In this way, the bonding members 7a and 7b that bond the light-emitting portion 2 to the LDD 9 according to the fourth embodiment are arranged near the end of the light-emitting portion 2, rather than directly below the light-emitting portion 2. Therefore, the region directly below the light-emitting portion 2 can be used for purposes other than the arrangement of the bonding member 7, and there are fewer restrictions on the location of the bonding member 7, allowing for a greater degree of freedom in design.

### (Fifth Embodiment)

In the first to fourth embodiments, the light-emitting portion 2 and the LDD 9 are arranged so as to overlap when viewed in a plan view from the normal direction of the substrate surface of the first substrate 4. In contrast to this, in the fifth embodiment, the light-emitting portion 2 and the LDD 9 are arranged so as not to overlap.

Fig. 7 is a cross-sectional view of the distance-measuring device 1 according to the fifth embodiment. In Fig. 7, the same components as those in Fig. 1 are designated by the same reference numerals, and differences will be mainly described below.

In the distance-measuring device 1 of Fig. 7, the light-emitting portion 2 and the LDD 9 are arranged so as not to overlap when viewed in a plan view from the normal direction of the substrate surface of the first substrate 4. For example, the LDD 9 of the second substrate 5 is arranged at a position shifted from directly below the light-emitting portion 2 of the first substrate 4, for example, near the end of the second substrate 5. A bonding member 7a is provided that extends from near the end of the light-emitting portion 2 in the depth direction of the first substrate 4. This bonding member 7a extends to the second substrate 5. The second substrate 5 has a bonding member 7b extending from the LDD 9 in a direction substantially parallel to the substrate surface, and the bonding member 7b is bonded to the bonding member 7a described above.

Thus, the location of the LDD 9 is not necessarily limited to directly below the light-emitting portion 2, and it may be located at any location on the second substrate 5. For example, if the readout circuit 6 provided on the second substrate 5 requires an area larger than that of the light-receiving portion 3 provided on the first substrate 4, the readout circuit 6 may be arranged up to directly below the light-emitting portion 2 of the first substrate 4. In this case, the LDD 9 cannot be arranged on the second substrate 5 so as to overlap with the light-emitting portion 2.

In the present embodiment, the LDD 9 can be arranged on the second substrate 5 regardless of the location of the light-emitting portion 2 of the first substrate 4, so that the degree of freedom in design can be increased. In the present embodiment, the location of the bonding member 7 for bonding to the light-emitting portion 2 can be determined according to the location of the LDD 9.

### (Sixth Embodiment)

In the first to fifth embodiments, the readout circuit 6 is provided on the second substrate 5, but in some cases, it may be desirable to arrange a portion of the readout circuit 6 close to the light-receiving portion 3 in terms of electrical characteristics. For example, it is desirable to arrange a source follower circuit, which is a portion of the readout circuit 6, close to the light-receiving portion 3 for the purpose of noise reduction and the like. The source follower circuit is a circuit that transmits a voltage signal generated by photoelectric conversion in the light-receiving portion 3 to a signal wiring connected to the readout circuit 6 with low impedance. Therefore, in the distance-measuring device 1 according to the sixth embodiment, a portion of the readout circuit such as the source follower circuit is arranged on the first substrate 4.

Fig. 8 is a plan view of the light-receiving portion 3 on the first substrate 4. As shown in Fig. 8, the light-emitting portion 2, the light-receiving portion 3, and a portion 6a of the readout circuit 6 are arranged on the first substrate 4. The portion 6a of the readout circuit includes, for example, a source follower circuit. Since a source follower circuit is provided for each pixel 60, the portion 6a of the readout circuit including a source follower circuit is arranged on the first substrate 4 in association with each of the photoelectric conversion elements 3a constituting the light-receiving portion 3.

The portion 6a of the readout circuit provided on the first substrate 4 and the readout circuit on the second substrate 5 are bonded by a bonding member 7 such as Cu-Cu bonding, bumps, or vias.

The light-emitting portion 2 side of the distance-measuring device 1 in Fig. 8 is configured in the same manner as in Fig. 1. The light-emitting portion 2 side of the distance-measuring device 1 in Fig. 8 may be configured in the same manner as in Fig. 5 to reduce the height of the first substrate 4.

In this way, in the sixth embodiment, the portion 6a of the readout circuit provided on the second substrate 5 is provided on the first substrate 4, so that a source follower circuit or the like can be arranged near the light-receiving portion 3, and the light-receiving characteristics of the light-receiving portion 3 can be improved.

### (Seventh Embodiment)

Fig. 9 is a plan view of a distance-measuring device 1 according to the seventh embodiment. The light-emitting portion 2 has a plurality of light-emitting elements 2a. The light-emitting elements 2a are arranged adjacent to each other in the first direction X and the second direction Y. The light-receiving portion 3 has a plurality of photoelectric conversion elements 3a. The photoelectric conversion elements 3a are arranged adjacent to each other in the first direction X and the second direction Y.

In Fig. 9, the light-emitting portion 2 and the light-receiving portion 3 are arranged adjacent to each other in the first direction X of the first substrate 4. The light-emitting elements 2a constituting the light-emitting portion 2 are arranged adjacent to each other, so that the light-emitting portion 2 can emit surface light. The photoelectric conversion elements 3a constituting the light-receiving portion 3 are arranged adjacent to each other, so that surface light can be received by the photoelectric conversion elements 3a. This allows distance measurement of objects located over a wide range.

Fig. 10 is a plan view of a distance-measuring device 1 according to a first modified example of the seventh embodiment. In Fig. 9, the arrangement region of the plurality of photoelectric conversion elements 3a in the light-receiving portion 3 is provided adjacent to the arrangement region of the plurality of light-emitting elements 2a in the light-emitting portion 2. However, in Fig. 10, the plurality of light-emitting elements 2a and the plurality of photoelectric conversion elements 3a are arranged in a mixed manner in the same arrangement region.

In the case of Fig. 10, the distance between the light-emitting element 2a and the photoelectric conversion element 3a can be made narrower than in Fig. 9, and the distance-measuring device 1 can be made smaller than that of Fig. 9.

Fig. 11 is a plan view of a distance-measuring device 1 according to a second modified example of the seventh embodiment. In Fig. 11, the plurality of photoelectric conversion elements 3a in the light-receiving portion 3 are arranged close to each other in the first direction X and the second direction Y, and the plurality of light-emitting elements 2a in the light-emitting portion 2 are arranged to surround the light-receiving portion 3. Contrary to Fig. 11, the light-emitting elements 2a in the light-emitting portion 2 may be arranged close to each other in the first direction X and the second direction Y, and the photoelectric conversion elements 3a in the light-receiving portion 3 may be arranged so as to surround the light-emitting portion 2.

In this way, in the seventh embodiment, when the light-emitting portion 2 has a plurality of light-emitting elements 2a and the light-receiving portion 3 has a plurality of photoelectric conversion elements 3a, the light-emitting elements 2a and the photoelectric conversion elements 3a can be arranged in any arrangement, so that the degree of freedom in design can be increased.

### (Specific Configuration of Distance-measuring Device 1)

The distance-measuring device 1 according to the first to seventh embodiments can be applied to the dToF (direct ToF) method and the iToF (indirect ToF) method. The dToF method is a method of measuring distance based on the time difference between the light-emission timing of the light-emitting portion 2 and the light-reception timing of the light-receiving portion 3. The iToF method is a method of measuring distance based on the phase difference between the phase of the light-emission signal of the light-emitting portion 2 and the phase of the light-reception signal of the light-receiving portion 3.

Fig. 12 is a block diagram of the distance-measuring device 1 according to the first to seventh embodiments. Fig. 12 shows the block configuration of the distance-measuring device 1 of the dToF method. The distance-measuring device 1 of Fig. 1 includes a light-emitting portion 2, a distance-measuring unit 51, and an overall control unit 52.

The light-emitting portion 2 includes a plurality of light-emitting elements 2a, a driving circuit 53, a clock generation unit 54, and a light-emission control unit 55.

The plurality of light-emitting elements 2a are arranged in the first direction X and the second direction Y intersecting each other. The plurality of light-emitting elements 2a repeatedly emit light-emission pulse signals at a predetermined time interval. The light-emitting portion 2 can scan a predetermined two-dimensional space with the light signals emitted by the plurality of light-emitting elements 2a. A specific method for scanning the light signals is not particularly limited. The light-emitting elements 2a are, for example, VCSELs.

The driving circuit 53 drives the light-emitting elements 2a based on a control signal from the light-emission control unit 55. For example, the driving circuit 53 controls at least one of the light-emission timings and the light-emission waveforms of the optical pulse signal based on the control signal from the light-emission control unit 55. More specifically, the driving circuit 53 controls the voltage level of the voltage applied to the anode or cathode of the light-emitting elements 2a based on the control signal from the light-emission control unit 55 to control at least one of the signal intensity, optical peak intensity, pulse width, rising edge timing, falling edge timing, and slew rate of the optical pulse signal from the light-emitting elements 2a.

The clock generation unit 54 generates a clock signal synchronized with a reference clock signal. The reference clock signal is, for example, a signal input from outside the distance-measuring device 1. Alternatively, the reference clock signal may be generated inside the distance-measuring device 1.

The light-emission control unit 55 generates a control signal for controlling at least one of the light-emission timings and light-emission waveforms of each light-emitting element 2a in synchronization with the clock signal. At least one of the driving circuit 53, the clock generation unit 54, and the light-emission control unit 55 is provided in the LDD 9.

The overall control unit 52 controls the light-emitting portion 2 and the distance-measuring unit 51. At least one of the light-emitting portion 2 and the overall control unit 52 may be integrated into the distance-measuring unit 51.

The distance-measuring unit 51 has a pixel array unit 61, a distance measurement processing unit 62, a control unit 63, a clock generation unit 64, a light-emission timing control unit 65, a driving circuit 66, and an output buffer 67. The pixel array unit 61 constitutes the light-receiving portion 3.

The pixel array unit 61 has a plurality of pixels 60 arranged in the first direction X and the second direction Y. The pixels 60 receive a reflected light signal from the object 50. The pixels 60 output a voltage signal in response to the arrival of a photon. It is also possible to detect the light intensity of the reflected light signal by averaging the results of repeatedly receiving the reflected light signal at each pixel 60.

Each of the pixels 60 has a photoelectric conversion element 3a. The photoelectric conversion element 3a is, for example, a SPAD (Single Photon Avalanche Photo Diode). Each pixel 60 may have a quench circuit (not shown). In the initial state, the quench circuit supplies a reverse bias voltage between the anode and cathode of the SPAD with a potential difference exceeding the breakdown voltage. After the SPAD detects a photon, the driving circuit 66 supplies a reverse bias voltage to the SPAD via the corresponding quench circuit to prepare for the detection of the next reflected light pulse signal.

The distance measurement processing unit 62 has a time-to-digital converter (TDC) 71, a histogram generation unit 72, a signal processing unit 73, and a distance measurement control unit 74.

The TDC 71 generates a time digital signal corresponding to the reception time of the reflected light pulse signal received by the SPAD with a predetermined time resolution. The histogram generation unit 72 generates a histogram with a bin width corresponding to the time resolution of the TDC 71 based on the time digital signal generated by the TDC 71. The bin width is the width of each frequency unit that constitutes the histogram. The higher the time resolution of the TDC 71, the narrower the bin width can be, and a histogram that more accurately reflects the time frequency of receiving the reflected light pulse signal can be obtained.

The signal processing unit 73 calculates the distance to the object 50 by calculating the center of gravity of the reflected light pulse signal based on the histogram, and outputs it via the output buffer 67.

The control unit 63 controls the processing operations of each unit in the distance-measuring unit 51. The distance measurement control unit 74 controls the TDC 71, histogram generation unit 72, and signal processing unit 73 in the distance measurement processing unit 62. The light-emission timing control unit 65 controls the light-emission control unit 55 in the light-emitting portion 2 and also controls the driving circuit 66. The driving circuit 66 performs quench control to restore the cathode voltage to its original voltage when the plurality of pixels 60 in the pixel array unit 61 detect light and the cathode voltage drops.

The clock generation unit 64 generates a clock signal used by the TDC 71 and the histogram generation unit 72. The clock generation unit 64 generates the clock signal using, for example, a PLL circuit (not shown).

At least one of the driving circuit 66, the distance measurement processing unit 62, the control unit 63, the clock generation unit 64, and the light-emission timing control unit 65 is provided in the readout circuit 6 of the second substrate 5. Among the driving circuit 66, the distance measurement processing unit 62, the control unit 63, the clock generation unit 64, and the light-emission timing control unit 65, the parts not included in the readout circuit 6 may be arranged on the first substrate 4.

The overall control unit 52 is provided in the LDD 9 or the readout circuit 6. Alternatively, the overall control unit 52 may be arranged on the first substrate 4.

In this way, the distance-measuring device 1 of Fig. 12 can be arranged on the first substrate 4 and the second substrate 5, and can be configured with a single semiconductor chip.

### (Application Examples)

The technology according to the present disclosure can be applied to various products. For example, the technology according to the present disclosure may be implemented as an apparatus mounted on any kind of mobile body such as an automobile, an electric vehicle, a hybrid electric vehicle, a motorcycle, a bicycle, a personal mobility, an airplane, a drone, a ship, a robot, a construction machine, or an agricultural machine (tractor).

Fig. 13 is a block diagram illustrating a schematic configuration example of a vehicle control system 7000 that is an example of a mobile body control system to which the technique according to the present disclosure is applicable. The vehicle control system 7000 includes a plurality of electronic control units connected via a communication network 7010. In the example illustrated in Fig. 13, the vehicle control system 7000 includes a drive system control unit 7100, a body system control unit 7200, a battery control unit 7300, a vehicle exterior information detection unit 7400, a vehicle interior information detection unit 7500, and an integrated control unit 7600. The communication network 7010 connecting the plurality of control units may be, for example, an in-vehicle communication network compliant with any standards such as CAN (Controller Area Network), LIN (Local Interconnect Network), LAN (Local Area Network), and FlexRay (registered trademark).

Each control unit includes a microcomputer that performs arithmetic processing according to various programs, a storage unit that stores programs executed by the microcomputer, parameters used for various arithmetic operations, and the like, and a driving circuit that drives various control target devices. Each control unit includes a network I/F for performing communication with other control units via the communication network 7010, and includes a communication I/F for performing communication through wired communication or wireless communication with devices, sensors, or the like inside or outside the vehicle. In Fig. 13, a microcomputer 7610, a general-purpose communication I/F 7620, a dedicated communication I/F 7630, a positioning unit 7640, a beacon reception unit 7650, an in-vehicle device I/F 7660, an audio/image output unit 7670, a vehicle-mounted network I/F 7680, and a storage unit 7690 are shown as functional configurations of the integrated control unit 7600. The other control units also include a microcomputer, a communication I/F, a storage unit, and the like.

The drive system control unit 7100 controls the operations of devices related to the drive system of the vehicle according to various programs. For example, the drive system control unit 7100 functions as a control device for a driving force generation device for generating a vehicle driving force of an internal combustion engine or a drive motor, a driving force transmission mechanism for transmitting the driving force to wheels, a steering mechanism for adjusting a steering angle of the vehicle, a braking device that generates a braking force of the vehicle. The drive system control unit 7100 may have a function as a control device, for example, an ABS (Antilock Brake System) or ESC (Electronic Stability Control).

A vehicle state detector 7110 is connected to the drive system control unit 7100. The vehicle state detector 7110 includes, for example, at least one of a gyro sensor that detects an angular velocity of an axial rotation motion of a vehicle body, an acceleration sensor that detects an acceleration of a vehicle, and sensors for detecting an amount of operation with respect to an accelerator pedal, an amount of operation with respect to a brake pedal, a steering angle of a steering wheel, an engine speed, a rotation speed of wheels, and the like. The drive system control unit 7100 performs arithmetic processing using a signal input from the vehicle state detector 7110 to control an internal combustion engine, a drive motor, an electric power steering device, a brake device, and the like.

The body system control unit 7200 controls operations of various devices equipped in the vehicle body in accordance with various programs. For example, the body system control unit 7200 functions as a control device of a keyless entry system, a smart key system, a power window device, or various lamps such as a headlamp, a back lamp, a brake lamp, a turn indicator, and a fog lamp. In this case, radio waves emitted from a portable device in place of a key or signals of various switches can be input to the body system control unit 7200. The body system control unit 7200 receives inputs of radio waves or signals and controls a door lock device, a power window device, and a lamp of the vehicle.

The battery control unit 7300 controls a secondary battery 7310 which is a power supply source of a driving motor in accordance with various programs. For example, information such as a battery temperature, a battery output voltage, or a remaining capacity of a battery is input from a battery device including the secondary battery 7310 to the battery control unit 7300. The battery control unit 7300 performs arithmetic processing using such a signal and performs temperature adjustment control of the secondary battery 7310 or control of a cooling device equipped in the battery device.

The vehicle exterior information detection unit 7400 detects information outside of the vehicle in which the vehicle control system 7000 is mounted. For example, at least one of an imaging unit 7410 and a vehicle exterior information detector 7420 is connected to the vehicle exterior information detection unit 7400. The imaging unit 7410 includes at least one of a ToF (Time of Flight) camera, a stereo camera, a monocular camera, an infrared camera, and other cameras. The vehicle exterior information detector 7420 includes at least one of, for example, an environmental sensor for detecting a current weather or atmospheric phenomenon and a surrounding information detection sensor for detecting other vehicles, obstacles, or pedestrians or the like around the vehicle in which the vehicle control system 7000 is mounted.

The environmental sensor may be, for example, at least one of a raindrop sensor that detects rainy weather, a fog sensor that detects fog, a sunshine sensor that detects the degree of sunshine, and a snow sensor that detects snowfall. The surrounding information detection sensor may be at least one of an ultrasonic sensor, a radar device, and a LIDAR (Light Detection and Ranging, Laser Imaging Detection and Ranging) device. The imaging unit 7410 and the vehicle exterior information detector 7420 may be provided as independent sensors or devices or may be provided as a device in which a plurality of sensors or devices are integrated.

Here, Fig. 14 illustrates an example of installation positions of the imaging unit 7410 and the vehicle exterior information detector 7420. Imaging units 7910, 7912, 7914, 7916, and 7918 are provided, for example, at least one of a front nose, side mirrors, a rear bumper, a back door, and an upper part of a windshield in a vehicle cabin of the vehicle 7900. The imaging unit 7910 included in the front nose and the imaging unit 7918 included in the upper part of the windshield in the vehicle cabin mainly acquire an image in front of the vehicle 7900. The imaging units 7912 and 7914 included in the side mirrors mainly acquire images of the sides of the vehicle 7900. The imaging unit 7916 included in the rear bumper or the back door mainly acquires an image of the rear of the vehicle 7900. The imaging unit 7918 included in the upper part of the windshield in the vehicle cabin is mainly used for the detection of a preceding vehicle, a pedestrian, an obstacle, a traffic light, a traffic sign, a lane, or the like.

In Fig. 14, an example of shooting ranges of the respective imaging units 7910, 7912, 7914, and 7916 is illustrated. An imaging range a indicates an imaging range of the imaging unit 7910 provided on the front nose, imaging ranges b and c indicate imaging ranges of the imaging units 7912 and 7914 provided on the side mirrors, and an imaging range d indicates an imaging range of the imaging unit 7916 provided on the rear bumper or the back door. For example, a bird's-eye view image of the vehicle 7900 as viewed from above can be obtained when the image data captured by the imaging units 7910, 7912, 7914, and 7916 are superimposed.

Vehicle exterior information detectors 7920, 7922, 7924, 7926, 7928, and 7930 provided in a front, a rear, a side, a corner, and an upper part of the windshield in the vehicle cabin of the vehicle 7900 may be, for example, ultrasonic sensors or radar devices. The vehicle exterior information detectors 7920, 7926, and 7930 provided at the front nose, the rear bumper, the back door, and the upper part of the windshield in the vehicle cabin of the vehicle 7900 may be, for example, LIDAR devices. These vehicle exterior information detectors 7920 to 7930 are mainly used for the detection of a preceding vehicle, a pedestrian, an obstacle, or the like.

The description will be continued with reference to Fig. 13 again. The vehicle exterior information detection unit 7400 causes the imaging unit 7410 to capture an image of the outside of the vehicle and receives the captured image data. Further, the vehicle exterior information detection unit 7400 receives detection information from the connected vehicle exterior information detector 7420. When the vehicle exterior information detector 7420 is an ultrasonic sensor, a radar device, or a LIDAR device, the vehicle exterior information detection unit 7400 transmits ultrasonic waves, electromagnetic waves, or the like, and receives information on received reflected waves. The vehicle exterior information detection unit 7400 may perform object detection processing or distance detection processing for a person, a vehicle, an obstacle, a sign, a character on a road surface, or the like based on the received information. The vehicle exterior information detection unit 7400 may perform environment recognition processing for recognizing rainfall, fog, road surface situation, and the like based on the received information. The vehicle exterior information detection unit 7400 may calculate a distance to an object outside the vehicle based on the received information.

Further, the vehicle exterior information detection unit 7400 may perform image recognition processing or distance detection processing for recognizing a person, a vehicle, an obstacle, a sign, a character on a road surface, or the like based on the received image data. The vehicle exterior information detection unit 7400 may perform processing such as distortion correction or alignment on the received image data, and combine image data captured by the different imaging units 7410 to generate a bird's-eye view image or a panoramic image. The vehicle exterior information detection unit 7400 may perform viewpoint conversion processing using the image data captured by the different imaging units 7410.

The vehicle interior information detection unit 7500 detects information inside the vehicle. For example, a driver state detector 7510 that detects a driver's state is connected to the vehicle interior information detection unit 7500. The driver state detector 7510 may include a camera that images a driver, a biological sensor that detects biological information of the driver, or a microphone that collects a sound in the vehicle cabin. The biological sensor is provided on, for example, a seat surface, a steering wheel, or the like and detects biological information of an occupant sitting on the seat or the driver holding the steering wheel. The vehicle interior information detection unit 7500 may calculate the degree of fatigue or the degree of concentration of the driver or determine whether the driver is drowsing based on detected information input from the driver state detector 7510. The vehicle interior information detection unit 7500 may perform a noise cancellation process or the like on a collected sound signal.

The integrated control unit 7600 controls overall operations in the vehicle control system 7000 according to various programs. An input unit 7800 is connected to the integrated control unit 7600. The input unit 7800 is implemented by a device that can be operated for the input by a passenger, for example, a touch panel, a button, a microphone, a switch, or a lever. Data obtained by recognizing voice input through a microphone may be input to the integrated control unit 7600. The input unit 7800 may be, for example, a remote control device using infrared rays or other radio waves, or may be an externally connected device such as a mobile phone or a PDA (Personal Digital Assistant) in response to an operation on the vehicle control system 7000. The input unit 7800 may be, for example, a camera. In this case, the passenger can input information by gesture. Alternatively, data obtained by detecting a motion of a wearable device worn by the passenger may be input. Further, the input unit 7800 may include, for example, an input control circuit that generates an input signal based on information input by the passenger or the like using the input unit 7800 and outputs the input signal to the integrated control unit 7600. The passenger or the like inputs various types of data to the vehicle control system 7000 or instructs a processing operation by operating the input unit 7800.

The storage unit 7690 may include a ROM (Read Only Memory) that stores various programs to be executed by a microcomputer, and a RAM (Random Access Memory) that stores various parameters, calculation results, or sensor values or the like. The storage unit 7690 may be implemented by, for example, a magnetic storage device such as an HDD (Hard Disc Drive), a semiconductor storage device, an optical storage device, or a magnetooptical storage device.

The general-purpose communication I/F 7620 is a general-purpose communication interface that mediates communication with various devices present in an external environment 7750. The general-purpose communication I/F 7620 may have, implemented therein, a cellular communication protocol such as GSM (registered trademark) (Global System of Mobile Communications), WiMAX (registered trademark), LTE (registered trademark) (Long Term Evolution), or LTE-A (LTE-Advanced), or other wireless communication protocols such as wireless LAN (also referred to as Wi-Fi (registered trademark)) or Bluetooth (registered trademark). The general-purpose communication I/F 7620 may be connected to, for example, a device (for example, an application server or a control server) present on an external network (for example, the Internet, a cloud network, or a business-specific network) via a base station or an access point. The general-purpose communication I/F 7620 may be connected to terminals (for example, the terminals of the driver, pedestrians, or shops, or MTC (Machine Type Communication) terminals) near the vehicle by using, for example, the P2P (Peer To Peer) technique.

The dedicated communication I/F 7630 is a communication interface supporting a communication protocol formulated for the purpose of use in a vehicle. The dedicated communication I/F 7630 may implement, for example, a standard protocol such as a WAVE (Wireless Access in Vehicle Environment) that is a combination of IEEE802.11p of a lower layer and IEEE1609 of an upper layer, a DSRC (Dedicated Short Range Communications), or a cellular communication protocol. The dedicated communication I/F 7630 typically performs V2X communications as a concept including one or more of vehicle-to-vehicle communications, vehicle-to-infrastructure communications, vehicle-to-home communications, and vehicle-to-pedestrian communications.

For example, the positioning unit 7640 receives, from a GNSS (Global Navigation Satellite System) satellite, a GNSS signal (for example, from a GPS (Global Positioning System) satellite, a GPS signal), executes positioning, and generates position information including a latitude, longitude, and altitude of the vehicle. The positioning unit 7640 may specify a current position by exchanging signals with a wireless access point, or may acquire position information from a terminal such as a mobile phone, PHS, or smartphone having a positioning function.

The beacon reception unit 7650 receives radio waves or electromagnetic waves transmitted from a radio station or the like installed on a road, and acquires information such as a current position, traffic jam, no throughfare, or required time. A function of the beacon reception unit 7650 may be included in the above-described dedicated communication I/F 7630.

The in-vehicle device I/F 7660 is a communication interface that mediates connections between the microcomputer 7610 and various in-vehicle devices 7760 present in the vehicle. The in-vehicle device I/F 7660 may establish a wireless connection using wireless communication protocols such as a wireless LAN, Bluetooth (registered trademark), NFC (Near Field Communication), and WUSB (Wireless USB). Furthermore, the in-vehicle device I/F 7660 may establish a wired connection of, for example, a USB (Universal Serial Bus), HDMI (registered trademark) (High-Definition Multimedia Interface), or MHL (Mobile High-definition Link) via a connection terminal (not illustrated) (and a cable if necessary). The in-vehicle device 7760 may include, for example, at least one of a mobile device or a wearable device of a passenger and an information device carried in or attached to the vehicle. Further, the in-vehicle device 7760 may include a navigation device that searches for a route to an arbitrary destination. The in-vehicle device I/F 7660 exchanges control signals or data signals with the in-vehicle devices 7760.

The vehicle-mounted network I/F 7680 is an interface that mediates communication between the microcomputer 7610 and the communication network 7010. The vehicle-mounted network I/F 7680 transmits and receives signals or the like in conformity with a predetermined protocol supported by the communication network 7010.

The microcomputer 7610 of the integrated control unit 7600 controls the vehicle control system 7000 in accordance with various programs based on information acquired through at least one of the general-purpose communication I/F 7620, the dedicated communication I/F 7630, the positioning unit 7640, the beacon reception unit 7650, the in-vehicle device I/F 7660, and the vehicle-mounted network I/F 7680. For example, the microcomputer 7610 may calculate control target values for a driving force generation device, a steering mechanism, or a braking device based on acquired information on the inside and outside of the vehicle, and output control commands to the drive system control unit 7100. For example, the microcomputer 7610 may perform cooperative control for the purpose of implementing the functions of ADAS (Advanced Driver Assistance System), the functions including vehicle collision avoidance or impact mitigation, follow-up traveling based on an inter-vehicle distance, vehicle speed maintenance driving, a vehicle collision warning, and a vehicle lane departure warning. The microcomputer 7610 may perform coordinated control for automated driving in which a vehicle travels autonomously regardless of an operation of a driver, by controlling, for example, a driving force generation device, a steering mechanism, or a braking device based on acquired surrounding information on the vehicle.

The microcomputer 7610 may generate 3-dimensional distance information between the vehicle and objects such as surrounding structures or people based on information acquired via at least one of the general-purpose communication I/F 7620, the dedicated communication I/F 7630, the positioning unit 7640, the beacon reception unit 7650, the in-vehicle device I/F 7660, and the vehicle-mounted network I/F 7680 and may generate local map information including surrounding information of a present position of the vehicle. The microcomputer 7610 may predict a danger such as collision of the vehicle, approach of a pedestrian, or entry into a traffic prohibition road based on the acquired information and may generate a warning signal. The warning signal may be, for example, a signal for generating a warning sound or turning on a warning lamp.

The audio/image output unit 7670 transmits output signals of at least one of the audio and images to an output device capable of visually or audibly notifying a passenger of the vehicle or the outside of the vehicle of information. In the example of Fig. 13, an audio speaker 7710, a display unit 7720, and an instrument panel 7730 are illustrated as output devices. For example, the display unit 7720 may include at least one of an on-board display and a head-up display. The display unit 7720 may have an AR (Augmented Reality) display function. The output device may be other devices such as a headphone, a wearable device such as a glasses-type display worn by a passenger, a projector, and a lamp. When the output device is a display device, the display device visually displays results obtained through various processes performed by the microcomputer 7610 or information received from another control unit in various formats such as text, images, tables, and graphs. When the output device is a sound output device, the sound output device converts an audio signal formed by reproduced sound data, acoustic data, or the like into an analog signal and outputs the analog signal auditorily.

In the example illustrated in Fig. 13, at least two control units connected via the communication network 7010 may be integrated as one control unit. Alternatively, each control unit may be configured of a plurality of control units. Further, the vehicle control system 7000 may include another control unit (not illustrated). Further, in the above description, the other control unit may have some or all of functions of any one of the control units. That is, predetermined calculation processing may be performed by any one of the control units as long as information is transmitted and received via the communication network 7010. Similarly, a sensor or device connected to any one of the control units may be connected to the other control unit, and a plurality of control units may transmit or receive detection information to and from each other via the communication network 7010.

In the vehicle control system 7000 described above, the distance-measuring device 1 according to the present embodiment described with reference to Fig. 1 can be applied to the integrated control unit 7600 of the application example illustrated in Fig. 13.

Further, at least some of components of the distance-measuring device 1 described with reference to Fig. 1 and the like may be realized in a module for the integrated control unit 7600 illustrated in Fig. 13 (for example, an integrated circuit module configured of one die).

Note that the present technology can adopt the following configurations.
(1) A distance-measuring device that measures a distance to an object based on a reflected light signal received by a light-receiving portion, the reflected light signal being generated when a light pulse signal emitted from a light-emitting portion is reflected by the object, the distance-measuring device including:
   a first substrate formed of a Group-IV material on which the light-receiving portion and the light-emitting portion are integrally arranged; and
   a second substrate which is laminated on the first substrate and on which a readout circuit for reading out a light-reception signal received by the light-receiving portion is arranged.
(2) The distance-measuring device according to (1), wherein
   the light-receiving portion and the light-emitting portion are monolithically arranged on the first substrate.
(3) The distance-measuring device according to (1) or (2), wherein
   the first substrate is a silicon substrate.
(4) The distance-measuring device according to any one of (1) to (3), wherein
   the light-emitting portion contains a compound semiconductor material or a mixed crystal of the compound semiconductor material.
(5) The distance-measuring device according to (4), further including:
   a buffer layer arranged on the first substrate and formed of a Group-IV material different from the material of the first substrate, wherein
   the light-emitting portion is arranged on the buffer layer, and
   the material of the buffer layer has a lattice spacing closer to a lattice spacing of the light-emitting portion than the material of the first substrate.
(6) The distance-measuring device according to any one of (1) to (5), wherein
   the light-receiving portion includes a photodiode, an avalanche photodiode, or a SPAD (Single Photon Avalanche Diode).
(7) The distance-measuring device according to any one of (1) to (6), wherein
   at least a portion of the light-receiving portion overlaps with the readout circuit when viewed in a plan view from a normal direction of a substrate surface of the first substrate.
(8) The distance-measuring device according to any one of (1) to (7), wherein
   the light-emitting portion is arranged on the first substrate by selective epitaxial growth.
(9) The distance-measuring device according to any one of (1) to (8), further including:
   a light-shielding member containing a metal material arranged between an arrangement region of the light-receiving portion on the first substrate and an arrangement region of the light-emitting portion on the first substrate.
(10) The distance-measuring device according to any one of (1) to (9), wherein
   the light-emitting portion is arranged along a surface of the first substrate opposite to a surface facing the second substrate.
(11) The distance-measuring device according to any one of (1) to (9), wherein
   the light-emitting portion is arranged inside the first substrate.
(12) The distance-measuring device according to any one of (1) to (11), wherein
   the second substrate has a driving circuit that supplies a drive voltage to the light-emitting portion.
(13) The distance-measuring device according to (12), wherein
   at least a portion of the light-emitting portion overlaps with the driving circuit when viewed in a plan view from a normal direction of a substrate surface of the first substrate.
(14) The distance-measuring device according to (13), further including:
   a bonding member extending in a depth direction of the first substrate to connect the light-emitting portion and the driving circuit, wherein
   at least a portion of the bonding member is arranged in a region overlapping with the light-emitting portion when viewed in a plan view from the normal direction of the substrate surface of the first substrate.
(15) The distance-measuring device according to (13), further including:
   a bonding member extending in the depth direction of the first substrate to connect the light-emitting portion and the driving circuit, wherein
   at least a portion of the bonding member is arranged in a region not overlapping with the light-emitting portion when viewed in a plan view from the normal direction of the substrate surface of the first substrate.
(16) The distance-measuring device according to (12), wherein
   the driving circuit is arranged in a region not overlapping with the light-emitting portion when viewed in a plan view from the normal direction of the substrate surface of the first substrate.
(17) The distance-measuring device according to any one of (1) to (16), wherein
   a portion of circuits included in the readout circuit is arranged on the first substrate,
   the light-receiving portion has a plurality of photoelectric conversion elements arranged in a two-dimensional direction, each of which receives light, and
   the portion of the circuits has a plurality of pixel circuits connected to each of the plurality of photoelectric conversion elements.
(18) The distance-measuring device according to any one of (1) to (17), wherein
   the first substrate has the light-emitting portions and the light-receiving portions arranged adjacent to each other,
   each of the light-emitting portions has a plurality of light-emitting elements arranged closely to each other, and
   each of the light-receiving portions has a plurality of photoelectric conversion elements arranged closely to each other.
(19) The distance-measuring device according to any one of (1) to (17), wherein
   the light-emitting portion has a plurality of light-emitting elements, and
   the light-receiving portion has a plurality of light-receiving elements arranged between the plurality of light-emitting elements, or arranged to surround the plurality of light-emitting elements, or arranged to be surrounded by the plurality of light-emitting elements.
(20) The distance-measuring device according to any one of (1) to (19), wherein
   the light-emitting portion is a VCSEL (Vertical Cavity Surface Emitting Laser).
(21) A method for manufacturing a distance-measuring device, including:
   forming a light-receiving portion in a first region of a first substrate formed of a Group-IV material;
   forming a buffer layer formed of a Group-IV material different from the material of the first substrate on an upper surface of a second region of the first substrate;
   forming a light-emitting portion formed of a compound semiconductor material on the buffer layer by selective epitaxial growth; and
   bonding a second substrate to the first substrate, the second substrate having a readout circuit for reading out a light-reception signal received by the light-receiving portion and a driving circuit for supplying a drive voltage to the light-emitting portion.

Aspects of the present disclosure are not limited to the aforementioned individual embodiments and include various modifications that those skilled in the art can achieve, and effects of the present disclosure are also not limited to the details described above. In other words, various additions, modifications, and partial deletion can be made without departing from the conceptual idea and the gist of the present disclosure that can be derived from the details defined in the claims and the equivalents thereof.

### [Reference Signs List]

- 1: Distance-measuring device
- 2: Light-emitting portion
- 2a: Light-emitting element
- 2b: Light-emitting element group
- 3: Light-receiving portion
- 3a: Photoelectric conversion element
- 4: First substrate
- 5: Second substrate
- 6: Circuit
- 7: Bonding member
- 7a: Bonding member
- 7b: Bonding member
- 9: Driving circuit
- 10: Bonding member
- 11: Laminated film
- 12: Anode electrode
- 13: Cathode electrode
- 14: First multilayer reflective mirror
- 14: First multilayer reflective mirror
- 16: Active layer
- 18: Second multilayer reflective mirror
- 21: First support substrate
- 22: First semiconductor layer
- 23: Second semiconductor layer
- 25: Hard mask layer
- 25a: Opening
- 26: Buffer layer
- 27: GaAs layer
- 28: Second support substrate
- 29: Insulating layer
- 30: Insulating layer
- 31: Wiring layer
- 32: Insulating layer
- 33: Trench
- 40: Light-shielding member
- 41: Diffusion region
- 50: Object
- 51: Distance-measuring unit
- 52: Overall control unit
- 53: Driving circuit
- 54: Clock generation unit
- 55: Light-emission control unit
- 60: Pixel
- 61: Pixel array unit
- 62: Distance measurement processing unit
- 63: Control unit
- 64: Clock generation unit
- 65: Light-emission timing control unit
- 66: Driving circuit
- 67: Output buffer
- 71: Time-to-digital converter (TDC)
- 72: Histogram generation unit
- 73: Signal processing unit
- 74: Distance measurement control unit

## Claims

1. A distance-measuring device that measures a distance to an object based on a reflected light signal received by a light-receiving portion, the reflected light signal being generated when a light pulse signal emitted from a light-emitting portion is reflected by the object,
the distance-measuring device comprising:
a first substrate formed of a Group-IV material on which the light-receiving portion and the light-emitting portion are integrally arranged; and
a second substrate which is laminated on the first substrate and on which a readout circuit for reading out a light-reception signal received by the light-receiving portion is arranged.

2. The distance-measuring device according to claim 1, wherein
the light-receiving portion and the light-emitting portion are monolithically arranged on the first substrate.

3. The distance-measuring device according to claim 1, wherein
the first substrate is a silicon substrate.

4. The distance-measuring device according to claim 1, wherein
the light-emitting portion contains a compound semiconductor material or a mixed crystal of the compound semiconductor material.

5. The distance-measuring device according to claim 4, further comprising:
a buffer layer arranged on the first substrate and formed of a Group-IV material different from the material of the first substrate, wherein
the light-emitting portion is arranged on the buffer layer, and
the material of the buffer layer has a lattice spacing closer to a lattice spacing of the light-emitting portion than the material of the first substrate.

6. The distance-measuring device according to claim 1, wherein
the light-receiving portion includes a photodiode, an avalanche photodiode, or a SPAD (Single Photon Avalanche Diode).

7. The distance-measuring device according to claim 1, wherein
at least a portion of the light-receiving portion overlaps with the readout circuit when viewed in a plan view from a normal direction of a substrate surface of the first substrate.

8. The distance-measuring device according to claim 1, wherein
the light-emitting portion is arranged on the first substrate by selective epitaxial growth.

9. The distance-measuring device according to claim 1, further comprising:
a light-shielding member containing a metal material arranged between an arrangement region of the light-receiving portion on the first substrate and an arrangement region of the light-emitting portion on the first substrate.

10. The distance-measuring device according to claim 1, wherein
the light-emitting portion is arranged along a surface of the first substrate opposite to a surface facing the second substrate.

11. The distance-measuring device according to claim 1, wherein
the light-emitting portion is arranged inside the first substrate.

12. The distance-measuring device according to claim 1, wherein
the second substrate has a driving circuit that supplies a drive voltage to the light-emitting portion.

13. The distance-measuring device according to claim 12, wherein
at least a portion of the light-emitting portion overlaps with the driving circuit when viewed in a plan view from a normal direction of a substrate surface of the first substrate.

14. The distance-measuring device according to claim 13, further comprising:
a bonding member extending in a depth direction of the first substrate to connect the light-emitting portion and the driving circuit, wherein
at least a portion of the bonding member is arranged in a region overlapping with the light-emitting portion when viewed in a plan view from the normal direction of the substrate surface of the first substrate.

15. The distance-measuring device according to claim 13, further comprising:
a bonding member extending in the depth direction of the first substrate to connect the light-emitting portion and the driving circuit, wherein
at least a portion of the bonding member is arranged in a region not overlapping with the light-emitting portion when viewed in a plan view from the normal direction of the substrate surface of the first substrate.

16. The distance-measuring device according to claim 12, wherein
the driving circuit is arranged in a region not overlapping with the light-emitting portion when viewed in a plan view from the normal direction of the substrate surface of the first substrate.

17. The distance-measuring device according to claim 1, wherein
a portion of circuits included in the readout circuit is arranged on the first substrate,
the light-receiving portion has a plurality of photoelectric conversion elements arranged in a two-dimensional direction, each of which receives light, and
the portion of the circuits has a plurality of pixel circuits connected to each of the plurality of photoelectric conversion elements.

18. The distance-measuring device according to claim 1, wherein
the first substrate has the light-emitting portions and the light-receiving portions arranged adjacent to each other,
each of the light-emitting portions has a plurality of light-emitting elements arranged closely to each other, and
each of the light-receiving portions has a plurality of photoelectric conversion elements arranged closely to each other.

19. The distance-measuring device according to claim 1, wherein
the light-emitting portion has a plurality of light-emitting elements, and
the light-receiving portion has a plurality of light-receiving elements arranged between the plurality of light-emitting elements, or arranged to surround the plurality of light-emitting elements, or arranged to be surrounded by the plurality of light-emitting elements.

20. The distance-measuring device according to claim 1, wherein
the light-emitting portion is a VCSEL (Vertical Cavity Surface Emitting Laser).

21. A method for manufacturing a distance-measuring device, comprising:
forming a light-receiving portion in a first region of a first substrate formed of a Group-IV material;
forming a buffer layer formed of a Group-IV material different from the material of the first substrate on an upper surface of a second region of the first substrate;
forming a light-emitting portion formed of a compound semiconductor material on the buffer layer by selective epitaxial growth; and
bonding a second substrate to the first substrate, the second substrate having a readout circuit for reading out a light-reception signal received by the light-receiving portion and a driving circuit for supplying a drive voltage to the light-emitting portion.
